Europäisches Patentamt

European Patent Office

Office européen des brevets

(19)

(11) Veröffentlichungsnummer : **0 118 785**
**B1**

(12) **EUROPÄISCHE PATENTSCHRIFT**

(45) Veröffentlichungstag der Patentschrift :
27.05.87

(21) Anmeldenummer : **84101454.1**

(22) Anmeldetag : **13.02.84**

(51) Int. Cl.⁴ : **H 01 L 29/74**, H 01 L 29/10

(54) Zweipoliger Überstromschutz.

(30) Priorität : **16.02.83 SE 8300853**

(43) Veröffentlichungstag der Anmeldung :
**19.09.84 Patentblatt 84/38**

(45) Bekanntmachung des Hinweises auf die Patenterteilung : **27.05.87 Patentblatt 87/22**

(84) Benannte Vertragsstaaten :
**DE FR GB IT NL**

(56) Entgegenhaltungen :
**DE-A- 3 011 557**
**DE-B- 2 248 005**

(73) Patentinhaber : **ASEA AB**
**S-721 83 Västeras (SE)**

(72) Erfinder : **Svedberg, Per, Dipl.-Ing.**
**Björnskogsgränd 13**
**S-16246 Vällingby (SE)**

(74) Vertreter : **Boecker, Joachim, Dr.-Ing.**
**Rathenauplatz 2-8**
**D-6000 Frankfurt a.M. 1 (DE)**

## Beschreibung

Die Erfindung betrifft einen zweipoligen Überstromschutz zur Einfügung in eine stromführende Leitung gemäß dem Oberbegriff des Anspruches 1.

Überstromschütze dieser Art sind aus der DE-A-30 11 557 und der EP-A-0 096 651 bekannt. Ein solcher Überstromschutz besteht aus einem Thyristor, dessen Kathodenemitterübergang von einem mit dem Thyristor auf der gleichen Halbleiterscheibe integrierten MOS-Transistor kurzgeschlossen werden kann. Der Steuereingang des Thyristors ist über einen in dem Thyristor ausgebildeten Widerstand an den Anodenemitter angeschlossen. Bei normalen Betrieb erhält der Thyristor über diesen Widerstand Zündstrom und wird gezündet, sobald seine Sperrspannung einen niedrigen positiven Wert erreicht. Die Anodenspannung des Thyristors wird dem Steuereingang des normalerweise nichtleitenden MOS-Transistors zugeführt. Der Durchlaßspannungsfall des Thyristors wächst mit zunehmendem Strom. Bei einem bestimmten Wert des Thyristorstroms erreicht die Spannung am Steuereingang des Thyristors die Schwellspannung des Transistors. Der Transistor wird dann leitend und schließt den Kathodenemitterübergang kurz, wodurch der Thyristor gelöscht und der durch den Thyristor fließende Strom unterbrochen wird. Der Thyristor bleibt so lange im nichtleitenden Zustand, bis die am Thyristor liegende Spannung auf einen niedrigen Wert gesunken ist, was in einer Wechselstromleitung im Zusammenhang mit dem nächstfolgenden Nulldurchgang der Spannung der Fall ist.

Bei diesem bekannten Überstromschutz wird, wie vorstehend erwähnt, dem Steuereingang des Thyristors der von der Anode kommende Zündstrom über einen mit dem Thyristor integrierten Widerstand zugeführt. Um eine sichere Zündung des Thyristors bei niedriger Sperrspannung zu gewährleisten, ist es erforderlich, daß der Wert des genannten Widerstandes relativ klein ist. Ein ausreichend kleiner Widerstandswert hat jedoch den Nachteil, daß ein großer Leckstrom durch den Widerstand fließt, wenn der Thyristor aufgrund eines Überstroms gelöscht wurde und die Spannung am Thyristor folglich sehr groß ist. Dieser Leckstrom verursacht hohe Verluste im Überstromschutz und eine mangelhafte Isolation zwischen der treibenden Spannung und dem Schutzobjekt.

Der Erfindung liegt die Aufgabe zugrunde, einen Überstromschutz der eingangs genannten Art zu entwickeln, bei dem der Thyristor bei niedriger Sperrspannung sicher gezündet wird und gleichzeitig der Leckstrom bei gelöschtem Thyristor begrenzt wird, so daß man geringe Verluste und eine gute Isolation erhält. Außerdem soll der Überstromschutz einfach zu fertigen sein und die Fläche der Halbleiterscheibe besser ausnutzbar sein als bei den bekannten Überstromschützen.

Zur Lösung dieser Aufgabe wird ein Überstromschutz der eingangs genannten Art vorgeschlagen, der erfindungsgemäß die im kennzeichnenden Teil des Anspruches 1 genannten Merkmale hat.

Vorteilhafte Ausgestaltungen der Erfindung sind in den weiteren Ansprüchen genannt.

Anhand des in den Figuren gezeigten Ausführungsbeispiels soll die Erfindung näher erläutert werden. Es zeigen:

Figur 1 einen Schnitt durch einen in beiden Richtungen wirkenden Überstromschutz gemäß der Erfindung,

Figur 2 das Ersatzschaltbild des Überstromschutzes gemäß Figur 1,

Figur 3 im größeren Maßstab ein Detail des Überstromschutzes gemäß Figur 1.

Der Überstromschutz ist auf einen Halbleiterscheibe (Siliziumscheibe) mit einer N-leitenden Hauptschicht 1 ausgebildet. Auf der im Sinne der Figur oberen Fläche der Scheibe ist eine zentrale P-leitende Schicht 12 vorhanden, die von einer P-leitenden Schicht 14 umgeben ist. Auf der unteren Fläche der Scheibe sind in gleicher Weise eine zentrale P-leitende Schicht 22 und eine umgebende P-leitende Schicht 24 vorhanden. Die Bereiche 11 und 21 in den Schichten 12 und 22 sind stark P-dotiert. Die Schichten 12 und 22 sind an die Anschlußkontakte A und B des Überstromschutzes angeschlossen.

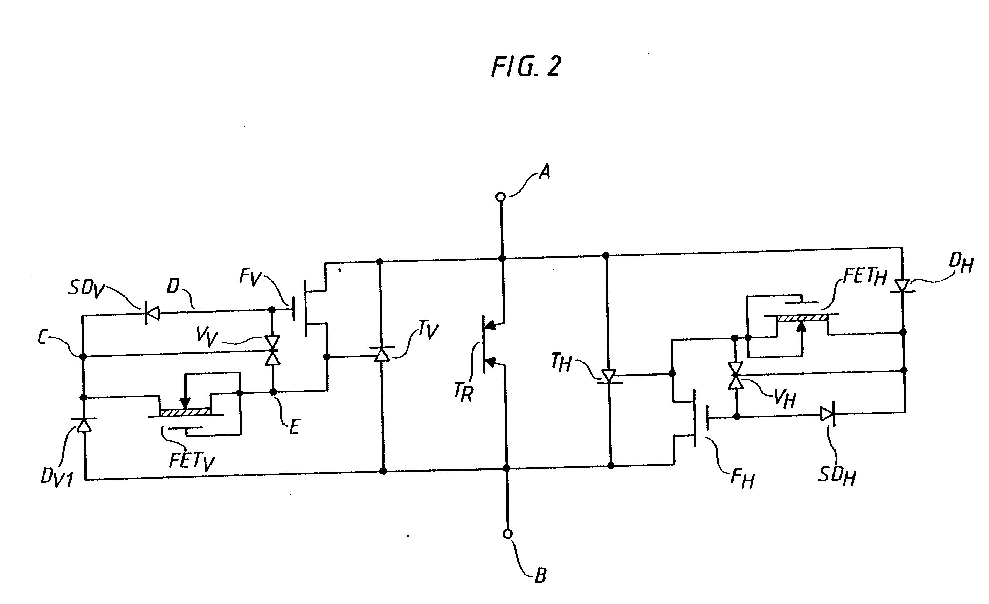

In der Schicht 14 ist eine $N^+$-leitende Schicht 13 angeordnet, die mit dem Kontakt A verbunden ist. Die Schichten 11, 12, 1, 22, 21 bilden einen PNP-Transistor, der in Figur 2 mit TR bezeichnet ist. Die Schichten 21, 22, 1, 14, 13 bilden einen Thyristor, der in Figur 2 mit $T_V$ bezeichnet ist. Nachstehend werden der Aufbau und die Arbeitsweise des in einer Richtung wirkenden Überstromschutzes beschrieben, der aus dem Kontakt B, den Schichten 21, 22 und 1 sowie aus den auf der oberen Fläche der Scheibe angeordneten Schichten und Kontakten, d. h. dem Transistor TR und dem Thyristor TV mit den an den letzteren angeschlossenen Komponenten zu seiner Zündung und Löschung besteht.

Um einen in zwei Richtungen wirkenden Überstromschutz zu erhalten, ist die untere Fläche der Siliziumscheibe in gleicher Weise wie die obere Fläche ausgebildet. Die Schichten und Kontakte auf der unteren Fläche haben die gleichen Bezeichnungen wie die entsprechenden Teile auf der oberen Fläche, wobei jedoch die erste Ziffer « 1 » durch die Ziffer « 2 » ersetzt ist. In Figur 2 haben die Bauteile der unteren Fläche den Index « H » und die entsprechenden Bauteile der oberen Fläche den Index « V ». Der Thyristor $T_H$ in Figur 2 besteht somit aus den Schichten 11, 12, 1, 24, 23, und die Komponenten zur Zündung und Löschung dieses Thyristors sind auf der unteren Fläche der Scheibe angeordnet.

Im folgenden wird die Arbeitsweise des Thyristors $T_V$ und des Transistorteils TR beschrieben.

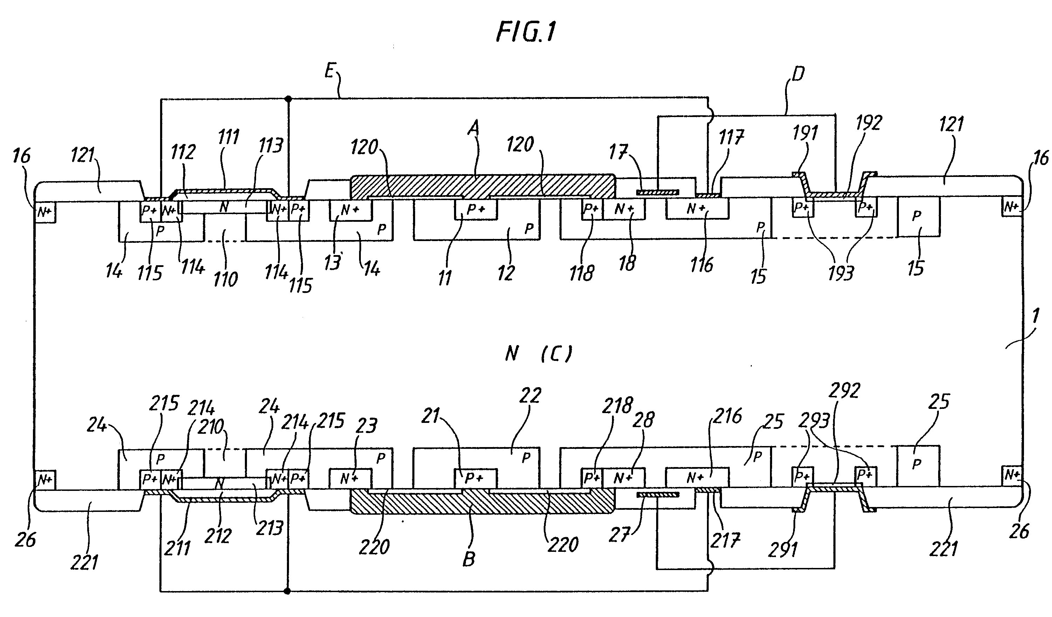

Der Thyristor $T_H$ mit seinen auf der unteren Fläche der in Figur 1 gezeigten Scheibe angeordneten Komponenten zur Zündung und Löschung hat denselben Aufbau und dieselbe Arbeitsweise. Der in den Figuren gezeigte Überstromschutz ist doppeltgerichtet, d. h. er arbeitet in beiden Strom- und Spannungsrichtungen. Falls gewünscht, kann der Überstromschutz als Ein-Richtungs-Schutz ausgebildet werden, indem beispielsweise auf der unteren Fläche der Scheibe alle in Figur 1 gezeigten Schichten und Kontakte außer den Schichten 21 und 22 und dem Kontakt B fortgelassen werden.

Der NPN-Teil 13, 14,1 des Thyristors $T_v$ hat einen stromabhängigen Injektionswirkungsgrad. Bei hohem Strom sinkt der Injektionswirkungsgrad der Emitterschicht 13. Dies hat zur Folge, daß die gesamte Stromverstärkung des Thyristors abnimmt und sich dem Wert 1 nähert, was wiederum eine Erhöhung des Durchlaßspannungsfalles des Thyristors zur Folge hat. Dies tritt bei einer Stromdichte von beispielsweise $10^5$ A/cm$^2$ ein. Durch Wahl des Verhältnisses aus der Fläche der Schicht 14 zur Gesamtfläche der Schichten 12 und 15 kann man die effektive Verstärkung für Löcher im Thyristor steuern, und dadurch kann man den Thyristorstrom bestimmen, bei dem der Durchlaßspannungsfall stark zuzunehmen beginnt.

Der Kontakt A ist von den Schichten 1, 12, 14 und 15 mit Hilfe einer darunterliegenden Siliziumdioxyd Schicht 120 isoliert. Eine oder mehrere P$^+$-Schichten 118 mit kleiner Ausdehnung im Verhältnis zu der Schicht 18 bewirken einen Kurzschluß des Emitterübergangs 18-15 und verhindern eine Zündung des parasitären Thyristorteils 21, 22, 1, 15, 18.

Die Halbleiterscheibe ist an ihrem Rand zu Verhinderung von Oberflächenleckströmen mit einem N$^+$-dotierten Bereich 16 versehen. Die Oberfläche der Halbleiterscheibe ist mit einer Schicht 121 aus Siliziumdioxyd belegt, die Öffnungen für die Kontakte hat.

Der zum Löschen des Thyristors bei Überstrom vorgesehene MOS-Transistor ($F_v$ in Fig. 2) besteht aus einer Schicht 116, die zusammen mit den Schichten 18 und 15 sowie der Steuerelektrode 17 einen MOSFET-Transistor des Anreicherungstyps mit einem P-leitenden Kanalbereich bildet. Die Schicht 116 hat einen Kontakt 117, der über eine Leitung E mit dem Kontakt 111 und damit durch die Schicht 115 mit der P-Basis 14 des Thyristors verbunden ist. Der Steuereingang 17 ist über eine Leitung D mit einem Kontakt 191 verbunden, unter dem eine dünne Schicht 192 in Platinsilizid umgewandelt ist und mit der Schicht 1 eine Schottky-Diode bildet. Ein Ring 193 aus P$^+$-leitendem Silizium ist um dem Rand der Schottky-Diode angebracht. Die Schottky-Diode ist in einer Öffnung in der Schicht 15 angebracht. Bei positiver Spannung am Thyristor (Kontakt B positiv gegenüber A) erhält die Steuerelektrode 17 positive Spannung über den Übergang 22-1 (Diode $D_v$ in Fig. 2) und die Schottky-Diode ($SD_v$ in Fig. 2). Der MOS-Transistor wird so bemessen, daß er bei einem gewünschten Durchlaßspannungsfall am Thyristor leitend wird, wobei er den Übergang zwischen den Schichten 13 und 14 kurzschließt und der Thyristor gesperrt wird. Der Abstand zwischen den Schichten 193 und 15 ist so gewählt, daß die Spannung, bei welcher die Sperrschicht des Übergangs zwischen den Schichten 1 und 15 in die Schicht 193 eindringt, kleiner als die Durchbruchspannung des Steuereinganges 17 ist. Hierdurch wird der MOS-Transistor gegen hohe am Thyristor auftretende Spannungen geschützt. Die Schichten 193-1-15 bilden einen PNP-Varistor, der in Figur 2 mit $V_v$ bezeichnet ist.

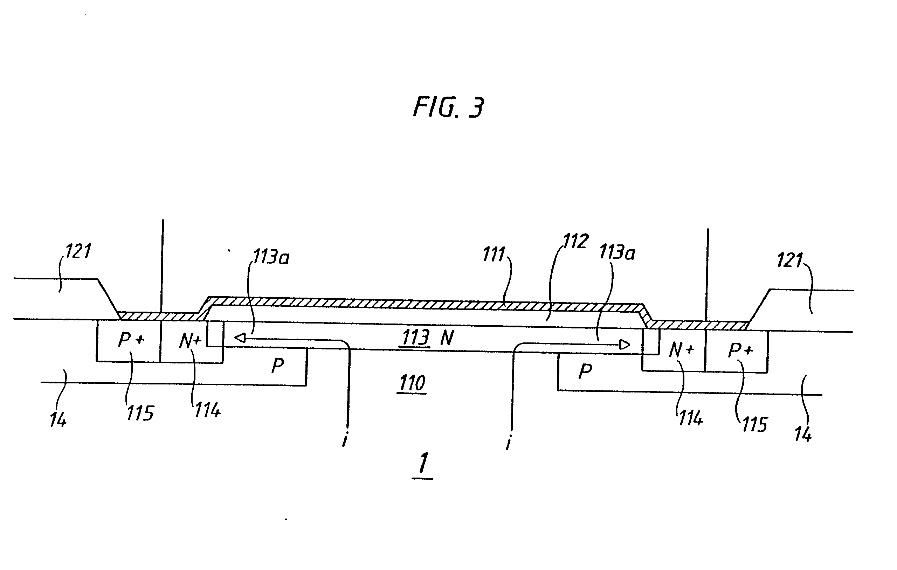

Zündstrom für den Thyristor wird der P-Basisschicht 14 über einen JFET-Transistor mit horizontalem Kanalbereich zugeführt. Dieser ist in Fig. 2 mit $FET_v$ bezeichnet und ist in Figur 3 detaillierter dargestellt. Die Schicht 14 ist mit einer Öffnung 110 versehen. Eine der Oberfläche am nächsten gelegene Schicht 113 der Halbleiterscheibe ist N-leitend. Am Rand der Schicht 113 ist eine N$^+$-leitende Schicht 114 und neben dieser eine P$^+$-leitende Schicht 115 angeordnet. Die Schicht 113 ist mit einer dünnen Siliziumdioxyd 112 bedeckt. Auf dieser Schicht und in Kontakt mit den Schichten 114 und 115 ist ein Kontakt 111 angeordnet, der über eine Verbindung E an den Kontakt 117 angeschlossen ist.

Bei Sperrspannung am Thyristor (Kontakt B positiv gegenüber A) fließt Strom von dem Kontakt B über die Schicht 21, die Schichten 22 und 1 (die Diode $D_v$ in Figur 2), die Öffnung 110, den Kanalteil 113, die Schicht 114, den Kontakt 111 und die Schicht 115 zu der P-Basisschicht 14 des Thyristors (die Pfeile i in Figur 3). Der Strom verursacht einen lateral gerichteten Spannungsfall im Kanalteil 113a, der als Vorspannung in Sperrichtung am Übergang zwischen den Schichten 113 und 14 liegt. Mit zunehmendem Strom breitet sich die Sperrschicht in dem Kanalbereich 113a nach oben hin aus und drosselt zunehmend den Kanal. Auf gleiche Weise wie bei einem konventionellen JFET-Transistor gibt es für den Kanalteil 113a hierdurch einen Sättigungsstrom, der nicht überschritten werden kann. Dieser Sättigungsstrom kann durch geeignete Wahl der Dotierung, Länge und Dicke des Kanalbereichs auf einen gewünschten Wert gebracht werden. Der Sättigungsstrom wird so bemessen, daß eine sichere Zündung des Thyristors stattfindet. Bei den hohen Spannungswerten, die an einem Thyristor auftreten können, wenn dieser mit Hilfe eines Feldeffekt Transistor $F_v$ gelöscht wird, wird der JFET-Transistor wie eine Konstantstromquelle arbeiten und seinen Strom automatisch auf den Sättigungsstrom begrenzen.

Bei einem Überstromschutz nach der Erfindung werden hierdurch die Verluste stark reduziert im Vergleich zu bekannten Überstromschützen gleicher Art. Ferner erhält man eine stark verbesserte Isolation zwischen der treibenden Spannung und dem Schutzobjekt. Außerdem vermeidet man die komplizierten, beispielsweise spiral- oder mäanderformigen Widerstände zur Begrenzung des Steuerstroms bekannter Überstromschütze. Dies ist einerseits fertigungstechnisch vorteilhaft, und andererseits vermeidet man den durch diese Widerstände bedingten verhältnismäßig großen Verlust an nutzbarer Fläche.

Die vorstehend beschriebene Ausführungsform eines Überstromschutzes mit einem JFET-Transistor mit einem horizontalen Kanalbereich für die Zufuhr von Zündstrom zu der Steuerschicht des Thyristors hat ferner den Vorteil, daß die Durchbruchspannung des Überstromschutzes (des Thyristors) nicht nachteilig beeinflußt wird. Dies wird zusätzlich dadurch gesichert, daß der Kontakt 111, der die gesamte Öffnung 110 in der P-Basisschicht 14 bedeckt, als Feldplatte wirkt und Unregelmäßigkeiten des Feldes an der Basisschicht verhindert.

Bei dem in den Figuren 1 und 3 gezeigten JFET-Transistorteil kann die Öffnung 110 quadratisch sein mit einer Seitenlänge von 20-40 $\mu$m sein. Der Kanalbereich 113a kann dieselbe Breite (20-40 $\mu$m) haben, während seine Länge jedoch um soviel größer ist, daß er sich 20-40 $\mu$m von der Öffnung nach rechts und nach links im Sinne der Figuren ausdehnt. Die Dicke der P-Basisschicht 14 kann 10 $\mu$m und die Dicke des Kanalbereichs 113 kann 0,5 $\mu$m betragen. Die Dotierung der N-Basisschicht 1 kann $10^{14}$ cm$^{-3}$ betragen. Die Schicht 14 kann erzeugt werden durch Ionenimplantation von Bor auf eine Oberflächenkonzentration von $10^{13}$ cm$^{-2}$, gefolgt von einer Indiffusion auf gewünschte Tiefe. Der Kanalbereich 113 wird erzeugt durch Ionenimplantation von Phosphor auf eine Oberflächenkonzentration von $3 \times 10^{11}$-$3 \times 10^{12}$ cm$^{-2}$. Der N$^+$-Bereich 114 und der P$^+$-Bereich 115 können danach durch Implantation von geeigneten Störsubstanzen erzeugt werden. Eine auf diese Weise ausgebildete JFET-Sektion hat einen Sättigungsstrom in einer Größenordnung von einigen Hundert $\mu$A, was ein angemessener Wert für einen Überstromschutz mit einem Nennstrom von einigen hundert Milliampere und einer Nennspannung von einigen hundert Volt sein kann.

Um einen Überstromschutz für höhere Nennströme zu erhalten, können mehrere untereinander identische Einheiten gemäß Figur 2 auf derselben Halbleiterscheibe integriert werden.

## Patentansprüche

1. Zweipoliger Überstromschutz für eine stromführende Leitung mit einem normalerweise leitenden, löschbaren Thyristor ($T_V$), bestehend aus einer ersten Emitterschicht (13), einer ersten Basisschicht (14), einer zweiten Basisschicht (1) und einer zweiten Emitterschicht (21, 22), die hintereinander in einem Halbleiterkörper angeordnet sind, und mit einem mit dem Thyristor integrierten MOS-Transistor ($F_V$), der zu dem PN-Übergang zwischen der ersten Emitterschicht (13) und der ersten Basisschicht (14) parallelgeschaltet und dazu vorgesehen ist, den PN-Übergang zur Löschung des Thyristors kurzzuschließen, wenn die Spannung am Thyristor einen bestimmten Wert überschreitet, dadurch gekennzeichnet, daß für die Zuführung des Zündstromes zum Thyristor in dem Halbleiterkörper ein Kanalbereich (113a) mit gleichem Leitungstyp (N) wie die zweite Basisschicht vorhanden ist, daß der Kanalbereich an die zweite Basisschicht (1) angrenzt, und daß der Kanalbereich zwischen einer Fläche des Halbleiterkörpers und einem von der ersten Basisschicht (14) gebildeten Bereich mit entgegengesetztem Leitungstyp (P) derart angeordnet ist, daß der durch den Kanalbereich (113a) fließende Strom mit steigender Spannung am Thyristor begrenzt wird und im wesentlichen parallel zu der genannten Fläche fließt.

2. Überstromschutz nach Anspruch 1, dadurch gekennzeichnet, daß die erste Basisschicht (14) mit einer Öffnung (110) versehen ist, durch welche sich die zweite Basisschicht (1) bis zur Oberfläche des Halbleiterkörpers erstreckt, und daß der Kanalbereich (113a) am Rande der Öffnung angeordnet ist.

3. Überstromschutz nach Anspruch 2, dadurch gekennzeichnet, daß eine an die erste Basisschicht (14) elektrisch angeschlossene leitende Schicht (111) auf einer über dem Kanalbereich (113a) und der Öffnung (110) angebrachten elektrisch isolierenden Schicht (112) angeordnet ist.

## Claims

1. Two-pole overcurrent protection device for a current-conducting conductor with a normally conducting turn-off thyristor ($T_V$) consisting of a first emitter layer (13), a first base layer (14), a second base layer (1) and a second emitter layer (21, 22), these layers being arranged in successive order in a semiconductor body, and with a MOS-transistor ($F_V$) integrated with the thyristor, the MOS-transistor being connected in parallel with the PN-junction between said first emitter layer (13) and said first base layer (14) and being provided to short-circuit the PN-junction for extinguishing the thyristor when the voltage across the thyristor exceeds a predetermined value, characterized in that there is a channel region (113a) of the same conduction type (N) as the second base layer for supplying gate trigger current to the thyristor in the semi-conductor body, that said channel region is arranged adjacent to said second base layer (1), and that said channel region is located between an area of the semiconductor body and a region of opposite conduction type (P) formed by said first base layer (14) in such a way that the current flowing through said channel region (113a) is limited when the voltage across the thyristor rises and flows substantially parallel to said area.

2. Overcurrent protection device according to claim 1, characterized in that said first base layer (14) is provided with an opening (110) through which the second base layer (1) extends up to the surface of said semiconductor body, and that the channel region (113a) is located at the edge of said opening.

3. Overcurrent protection device according to claim 2, characterized in that a conducting layer (111), which is electrically connected to said first base layer (14), is arranged on an electrically insulating layer (112) which is arranged on the channel region (113a) and the opening (110).

**Revendications**

1. Dispositif bipolaire de protection contre les surintensités pour un conducteur parcouru par un courant avec un thyristor ($T_V$) désamorçable, normalement passant, constitué par une première couche d'émetteur (13), par une première couche de base (14), par une seconde couche de base (1) et par une seconde couche d'émetteur (21, 22) qui sont disposées successivement dans un corps semi-conducteur, et avec un transistor MOS ($F_V$) intégré avec le transistor et qui est monté en parallèle sur la jonction PN entre la première couche d'émetteur (13) et la première couche de base (14) et est prévu pour court-circuiter la jonction PN pour désamorcer le thyristor lorsque la tension aux bornes du thyristor dépasse une certaine valeur, caractérisé par le fait que pour amener le courant d'amorçage au thyristor, il est prévu dans le corps semi-conducteur une zone de canal (113a) du même type de conductibilité (N) que la seconde couche de base, que la zone de canal jouxte la seconde couche de base (1), et que la zone de canal est disposée de telle façon entre une face du corps semi-conducteur et une zone formée par la première couche de base (14) et ayant le même type de conductibilité opposé (P), que le courant qui passe par la zone de canal (113a) est limité pour une tension croissante au niveau du thyristor et passe essentiellement en parallèle à ladite face.

2. Dispositif de protection contre les surintensités selon la revendication 1, caractérisé par le fait que la première couche de base (14) est pourvue d'une ouverture (110) à travers laquelle la seconde couche de base (1) s'étend jusqu'à la surface du corps semi-conducteur, et que la zone de canal (113a) est disposée sur le bord de l'ouverture.

3. Dispositif de protection contre les surintensités selon la revendication 1, caractérisé par le fait qu'une couche conductrice (111), reliée électriquement à la première couche de base (14), est disposée sur une couche électriquement isolante (112) déposée sur la zone de canal (113a) et sur l'ouverture (110).

FIG.1

0 118 785

FIG.2

2

FIG. 3